# EUROPEAN PATENT APPLICATION

(11) **EP 1 729 336 A1**
(43) Date of publication of application: **06.12.2006**
(21) Application number: 05730386.9
(22) Date of filing: 13.04.2005
(51) Int. Cl.: H01L 21/68, H01L 21/301

(54) **WAFER PROCESSING DEVICE AND WAFER PROCESSING METHOD**

(30) Priority: 14.04.2004 JP 2004119567; 28.04.2004 JP 2004133069; 26.05.2004 JP 2004155595
(71) Applicant: Lintec Corporation, Tokyo 173-0001 (JP)
(72) Inventor: TSUJIMOTO, Masaki, c/o. LINTEC CORPORATION, Tokyo 1730001 (JP); YOSHIOKA, Takahisa, c/o. LINTEC CORPORATION, Tokyo 1730001 (JP); KOBAYASHI, Kenji, c/o. LINTEC CORPORATION, Tokyo 1730001 (JP)
(74) Representative: Grünecker, Kinkeldey, Stockmair & Schwanhäusser Anwaltssozietät
(86) International application number: PCT/JP2005/007116
(87) International publication number: WO 2005/101486

(57) **Abstract**

A sticking apparatus 15 includes a sticking table 40 that supports a semiconductor wafer W, a sticking unit 41 that sticks a heat sensitive adhesive sheet S, and a cutter 96 that cuts the adhesive sheet for each semiconductor wafer in the width direction and in the periphery direction. The tables include a sticking table 40 that is controlled to a first temperature at which the adhesive sheet S is temporarily stuck to the wafer W, a periphery cutting table 47 that is controlled to a second temperature at which the viscosity of the adhesive sheet is reduced and cuts the adhesive tape in the peripheral direction, and a sticking table 48 that is controlled to a third temperature at which the adhesive sheet S is completely stuck to the wafer W.

## Description

### TECHNICAL FIELD

The present invention relates to a wafer processing apparatus and a wafer processing method, in particular, to a wafer processing apparatus and a wafer processing method capable of cutting heat sensitive adhesive sheet in accordance with the size of an object to be stuck (hereinafter, referred to as object) and reliably adhering the same to the object.

### BACKGROUND ART

It has been conventionally performed that a semiconductor wafer (hereinafter, simply referred to as "wafer") formed with circuit plane is separated into individual chips, thereafter each of the chips is picked up and bonded to a lead frame (die bonding). In wafer processing steps, the die bonding can be carried out after a heat sensitive adhesive sheet for die bonding is stuck to a wafer beforehand.

A sticking apparatus for the adhesive sheet as described above is disclosed in, for example, patent document 1. The sticking apparatus disclosed in the patent document 1 includes a first table that sucks and supports the wafer and maintains the adhesive sheet for a die bonding to a pre-heating temperature at which the adhesive sheet is temporarily stuck, a sheet supply unit that supplies the adhesive sheet to the upper face side of the wafer, a press roll that presses the adhesive sheet supplied to the upper face side of the wafer to stick temporarily the adhesive sheet to the wafer, a cutting means that cuts the adhesive sheet of the wafer along the peripheral edge, a second table that sucks and supports the wafer, on which the adhesive sheet is stuck temporarily and a heating unit disposed above the second table.
The wafer supported by the second table is arranged to be heated to a temperature higher than the pre-heating temperature by the heating unit, thereby the adhesive sheet is completely bonded to the wafer.

[Patent document 1] Japanese Patent Application Laid-Open No. 2003-257898

### DISCLOSURE OF THE INVENTION

### PROBLEMS TO BE SOLVED BY THE INVENTION

However, in the arrangement disclosed in the patent document 1, since the adhesive sheet is cut along the peripheral edge of the wafer in a state being heated to the pre-heating temperature, the adhesive sheet at the peripheral edge portion is in a state having a viscosity. Accordingly, there reside the following disadvantages. That is , the cutting operation cannot be carried out smoothly by the cutting means; further, during the cutting operation the adhesive agent is transferred to the blade edge portion of the cutting means, and thereby successive cutting operation of the adhesive sheet cannot be performed precisely, wherein the adhesive sheet is stuck to the wafer temporarily along the peripheral edge of the wafer.

Also, since the first table for temporary sticking of the adhesive sheet is maintained to provide a pre-heating temperature, when the adhesive sheet that is larger than the plane area of the wafer is stuck, adhesive sheet portion extending outside of the periphery edge of the wafer adheres occasionally to the table obstinately. Therefore, there resides another disadvantage such that, after the adhesive sheet has been cut along the outer edge of the wafer, unnecessary portion of adhesive sheet at the periphery side is hardly removed therefrom. On the other hand, if the unnecessary portion of adhesive sheet is intended not to be stuck at all to the first table, the unnecessary portion of adhesive sheet is in a free state. Accordingly, when the adhesive sheet is stuck to the wafer, the adhesive sheet is drawn by the tension for maintaining the posture and the press force of the press roll and wrinkles are generated, resulting in a state that air bubbles are caught between the wafer and the adhesive sheet, which causes a sticking failure of the adhesive sheet.

Further, in the arrangement disclosed in the patent document 1, when the robot arm transfers a wafer stuck with original sheet, in which the adhesive sheet and the protection tape are overlapped with each other to a table for peeling the protection tape, the temperature has to be returned to an ambient temperature once. Therefore, a period of time for cooling down is required. Accordingly, such a disadvantage is resulted that processing efficiency as the entire wafer-processing steps is reduced. Furthermore, when the wafer is transferred from the first table to the second table, there is such an arrangement that the temperature control is not performed but the wafer has to be heated after the wafer is transferred to the second table. This is also a factor to reduce the wafer processing efficiency.

### [OBJECT OF THE INVENTION]

The present invention has been proposed in view of the above disadvantages. It is an object of the present invention to provide a wafer processing apparatus and a wafer processing method that are, when a heat sensitive adhesive sheet is stuck to an object such as wafer and cut the tape to a size of the object, capable of preventing the adhesive agent from transferring to the cutting means side so that smooth cutting and sticking of the adhesive sheet to the object can be performed.

It is another object of the present invention is to provide a wafer processing apparatus that is, when the adhesive sheet is stuck to the wafer, capable of preventing unnecessary portion of adhesive sheet generated around the wafer from adhering obstinately on the surface of the sticking table, and when the adhesive sheet is stuck to the wafer, preventing wrinkles or the like from being generated in the adhesive sheet on the wafer.

It is still another object of the present invention is to provide a wafer processing apparatus that is, when sticking an adhesive sheet to a wafer requiring temperature control, capable of reducing the temperature control time so that the overall processing efficiency is enhanced.

### MEANS FOR SOLVING THE PROBLEMS

To achieve the object, the present invention is a wafer processing apparatus, which includes,
tables for supporting an object;
a sticking unit for supplying a heat sensitive adhesive sheet to the upper face of the object to stick the adhesive sheet to the object; and
a cutting means for cutting the adhesive sheet for each individual object, wherein
the tables are arranged to be controlled to a first temperature at which the adhesive sheet is temporarily stuck, to a second temperature at which the adhesion of the adhesive sheet is reduced and the adhesive sheet around the object is cut off, and to a third temperature at which the adhesive sheet is completely stuck to the object.

In the present invention, the tables include individual table so as to maintain the objects to the first, second or third temperature.

Also, the present invention is a wafer processing apparatus, which includes:
tables for supporting a semiconductor wafer as an object;
a sticking unit for supplying and sticking a heat sensitive adhesive sheet having a strip-shape to the upper face side of the semiconductor wafer; and
a cutting means for cutting the adhesive sheet for each semiconductor wafer,
wherein the cutting means has a width direction cutting function to cut the adhesive sheet in its width direction and a periphery direction cutting function to cut the adhesive sheet along the periphery of the semiconductor wafer,
the tables include a sticking table that is controlled to a first temperature and sticks temporarily the adhesive sheet to the semiconductor wafer, a periphery cutting table that is controlled to a second temperature that is lower than the first temperature and cuts the adhesive sheet around the semiconductor wafer, and an sticking table that is controlled to a third temperature that is higher than the first temperature and sticks completely the adhesive sheet to the semiconductor wafer.

The wafer processing apparatus further includes a transfer unit for transferring the semiconductor wafer, wherein the transfer unit includes a temperature control unit for controlling the temperature of the semiconductor wafer while transferring the semiconductor wafer between the tables.

Further, a transfer unit for transferring the semiconductor wafer stuck completely with the adhesive sheet to a mounting unit is further included, wherein the transfer unit includes a temperature control unit for controlling the temperature of the semiconductor wafer while transferring the semiconductor wafer to the mounting unit.

Furthermore, the sticking table includes an inner table section and an outer table section surrounding the inner table section, and the outer table section is controlled to a temperature lower than that of the inner table section.

Still further, such an arrangement is adopted that a heat transfer member is interposed between the inner table section and the outer table section, the heat transfer member heats the outer table section to a temperature lower than that of the inner table section.

Still furthermore, the temperature of each inner table section and outer table section is independently controlled.

Further, a die bonding sheet may be used for the adhesive sheet.

Further, a protection sheet that is cured to form a protection film may be used for the adhesive sheet.

Further, the cutting means includes a cutter, the extreme end position of the cutter is arranged to be adjustable between a position for cutting the adhesive sheet in the width direction and a position for cutting the adhesive sheet along the peripheral edge of the object.

Further, the present invention is a wafer processing method of sticking a heat sensitive adhesive sheet having a strip-shape to the upper face side of the semiconductor wafer, including the steps of:
sticking temporarily the adhesive sheet to the semiconductor wafer while maintaining the semiconductor wafer or a table supporting the same to a first temperature;
maintaining the semiconductor wafer stuck temporarily with the adhesive sheet to a second temperature that is lower than the first temperature; thereby reducing the adhesion of the adhesive sheet and cutting a sheet portion around the semiconductor wafer; and
controlling the temperature of the semiconductor wafer and adhesive sheet to a third temperature that becomes higher than the first temperature; thereby sticking completely the adhesive sheet to the semiconductor wafer.

The wafer processing method further includes a step of transferring the semiconductor wafer stuck completely with the adhesive sheet to a mounting unit via a transfer unit, and cooling down the semiconductor wafer during the transfer step through the transfer unit.

In this description, the wording "temporary stick" means a state of initial adhesion level, in which, when an adhesive sheet is stuck to an object such as wafer and cut in accordance with the configuration or the like of the object, the adhesive sheet stuck area is not peeled off or warped. The wording "complete stick" means a state of stronger adhesion than the "temporary stick" showing a state of adhesion level in which the adhesive sheet is not peeled off from the object in the following steps such as dicing step, pick up step or the like.

### EFFECT OF THE INVENTION

According to the present invention, the adhesive sheet is stuck temporarily to the object and afterwards the temperature is controlled to a second temperature at which the adhesion of the adhesive sheet lowers. Accordingly, the cutting operation can be carried out smoothly in the occasion of carrying out the cutting processing of the adhesive sheet at that temperature.
Consequently, when the adhesive sheet is cut along the periphery edge of the wafer as the object, adhesive agent does not transfer to the blade edge area of the cutter. Therefore, the cutting operation of each wafer for the object paid out successively can be carried out precisely.
Also, when it is arranged so that the tables for maintaining the first, second and third temperatures are independent from each other, the time lag due to different temperature control on one table is prevented, which enables the temperature control of each table to be simplified as well.
Furthermore, when the sticking table has an inner table section and an outer table section, and each of them is capable of controlling the temperature, even when a heat sensitive adhesive sheet is larger than the plane size of the semiconductor wafer, the area corresponding to the semiconductor wafer can be maintained to a temporary sticking temperature. Accordingly, such a disadvantage can be eliminated that the unnecessary portion outside the periphery of adhesive sheet, which is to be removed, adheres strongly to outer table. In this case, the unnecessary portion of adhesive sheet adheres to the outer table section with a strength that does not prevent the same from either being removed or peeled off. Therefore, such disadvantage that wrinkles in the adhesive sheet on the wafer occasionally generated in the case of non-sticking can be prevented.
Still further, the transfer unit can be provided with a temperature control function of the semiconductor wafer. Accordingly, while transferring the object, the object can be easily and swiftly controlled to a preset temperature. Furthermore, since the mounting unit does not have to control the temperature of the semiconductor wafer, mount processing can be carried out very quickly; hence processing efficiency as the entire wafer processing apparatus can be enhanced.
Still furthermore, since the cutting means has a cutting function both for the width direction and for the periphery direction, a single cutter can be used commonly resulting in a simplified structure.

### BRIEF DESCRIPTION OF DRAWINGS

[Fig. 1]

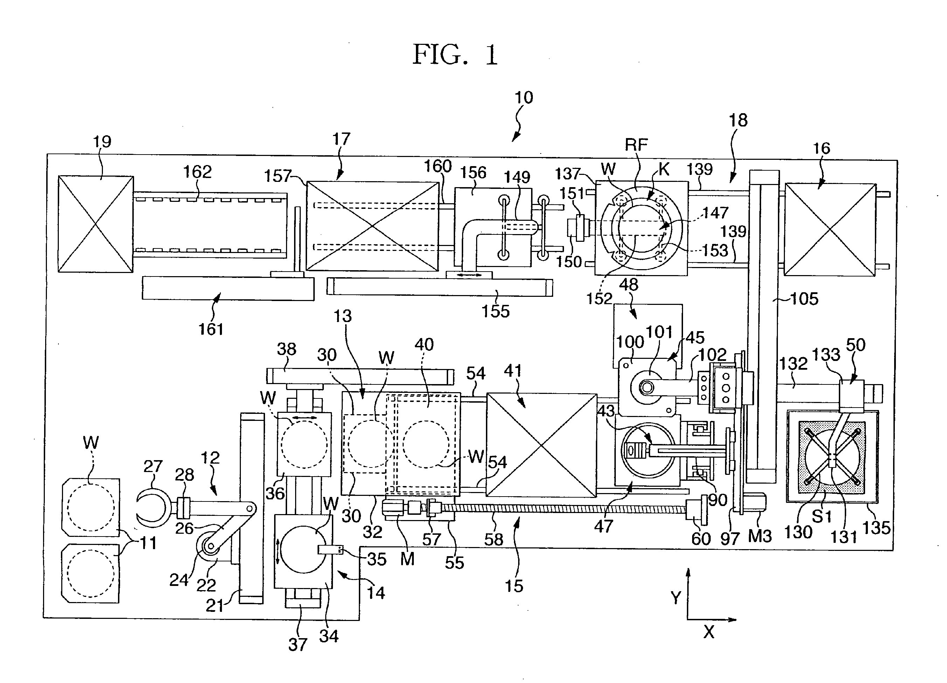

   Fig. 1 is a plan view schematically showing the entire constitution of a wafer processing apparatus in accordance with an embodiment of the present invention.
[Fig. 2]

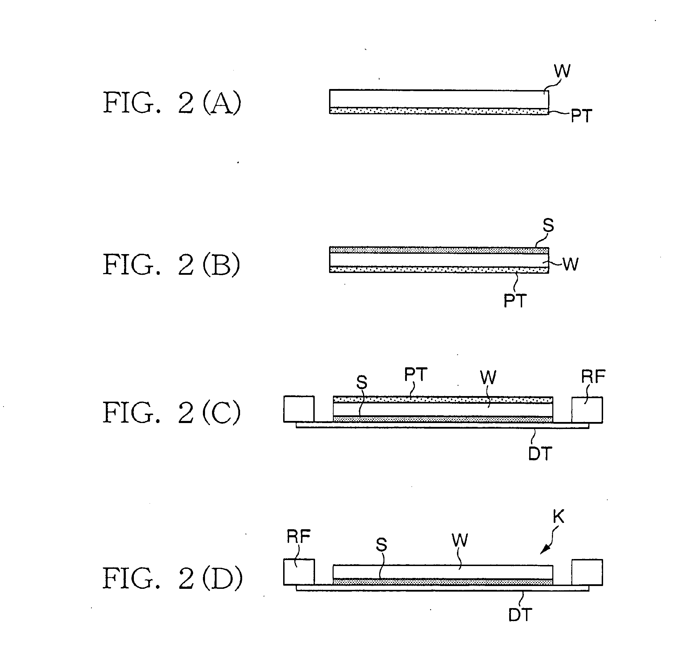

   Fig. 2 is a sectional view respectively for schematically illustrating the wafer processing steps in a time-lapse manner
[Fig. 3]

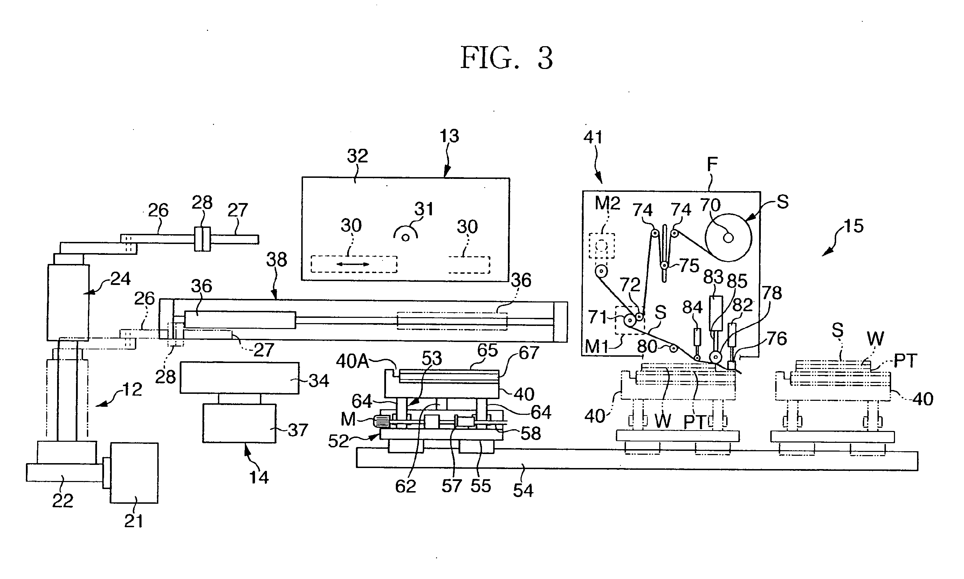

   Fig. 3 is a front elevation view showing an initial processing step of a wafer and a sticking apparatus therefor.
[Fig. 4]

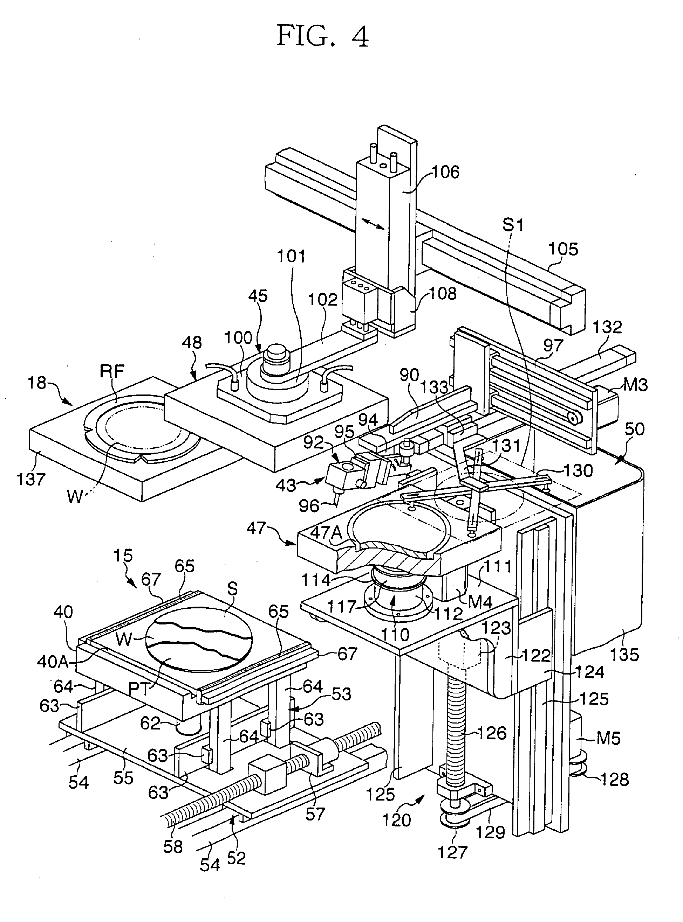

   Fig. 4 is a schematic perspective view of the sticking apparatus.
[Fig. 5]

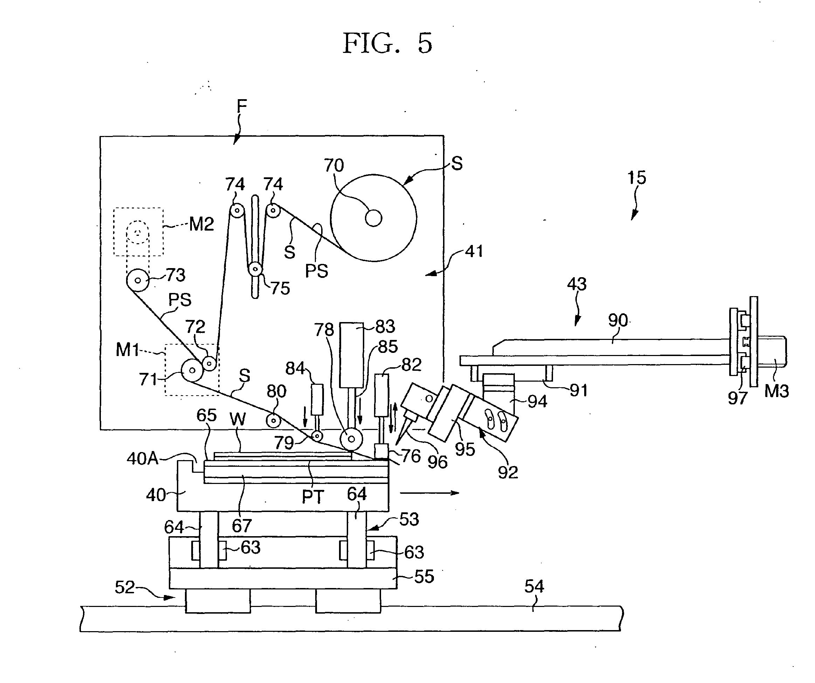

   Fig. 5 is a front elevation view schematically showing an initial step in which an adhesive sheet is temporarily stuck.
[Fig. 6]

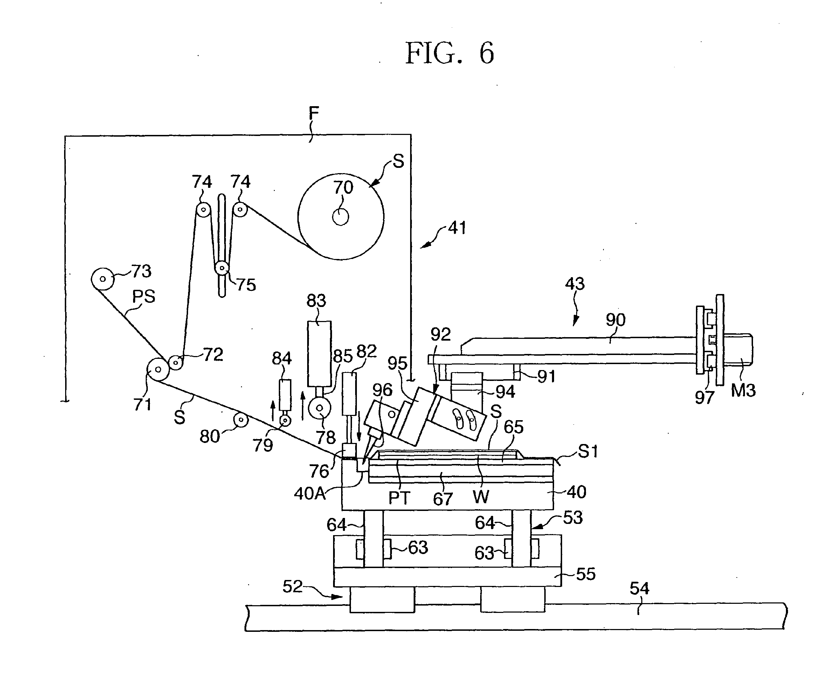

   Fig. 6 is a schematic front elevation view when the adhesive sheet is temporarily stuck and is cut in the width direction.
[Fig. 7]

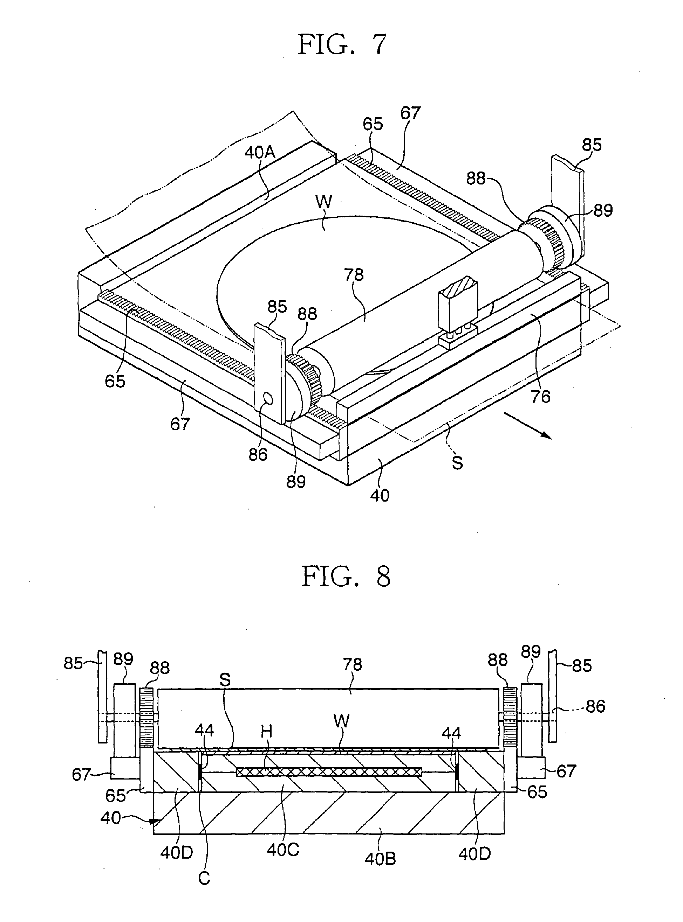

   Fig. 7 is a perspective view schematically showing a sticking table and an interlocking mechanism.
[Fig. 8]
   Fig. 8 is a partial sectional view of Fig. 7.
[Fig. 9]

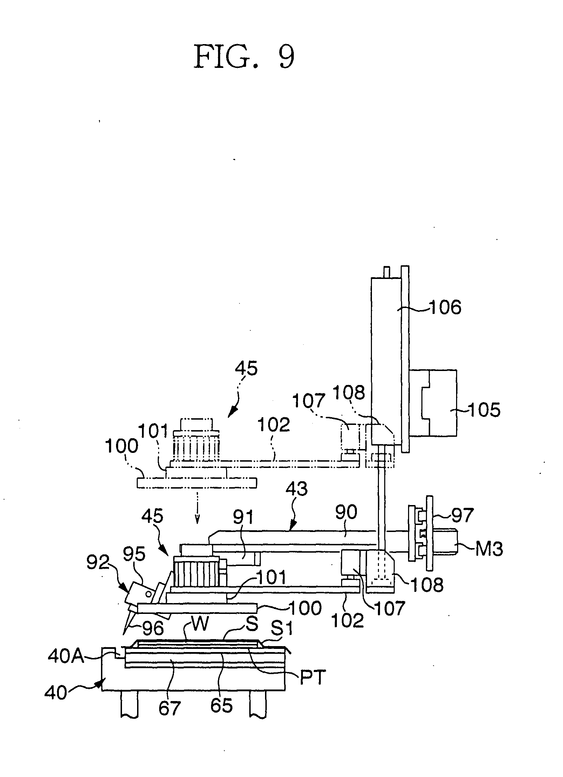

   Fig. 9 is a front elevation view schematically showing the operation of a cutting means.
[Fig. 10]

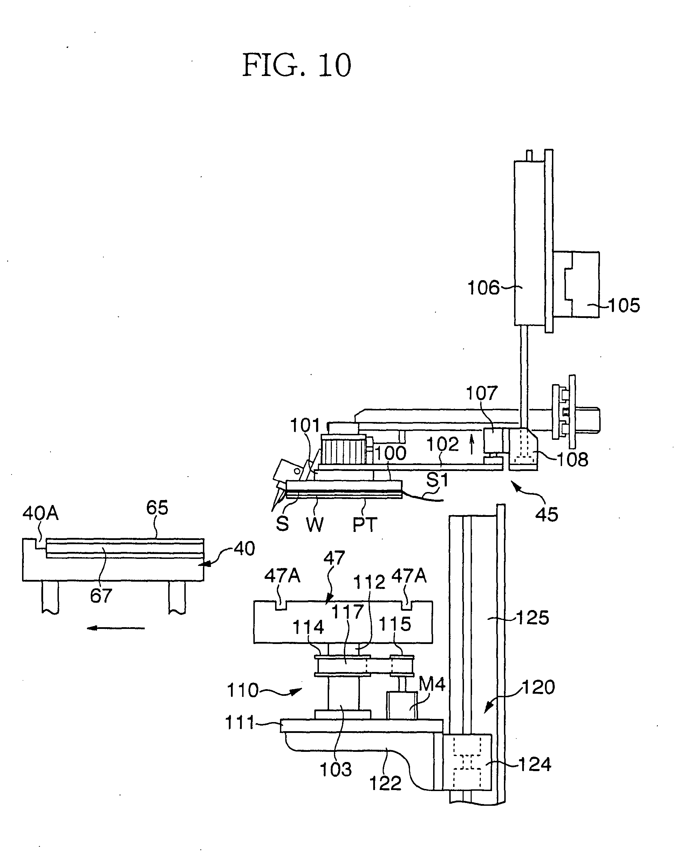

   Fig. 10 is a front elevation view schematically showing a state that a wafer is transferred to a periphery-cutting table from the sticking table.
[Fig. 11]

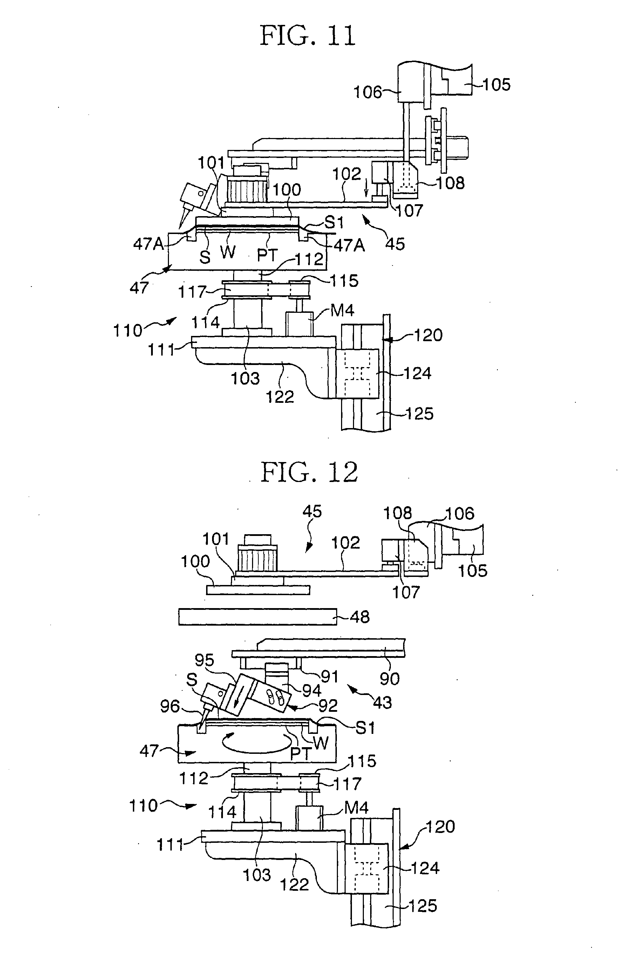

   Fig. 11 is a front elevation view schematically showing the step next to the step in Fig. 10.
[Fig. 12]
   Fig. 12 is a front elevation view schematically showing a state of cutting a portion of the sheet remaining around the periphery of a wafer transferred to the periphery-cutting table.
[Fig. 13]

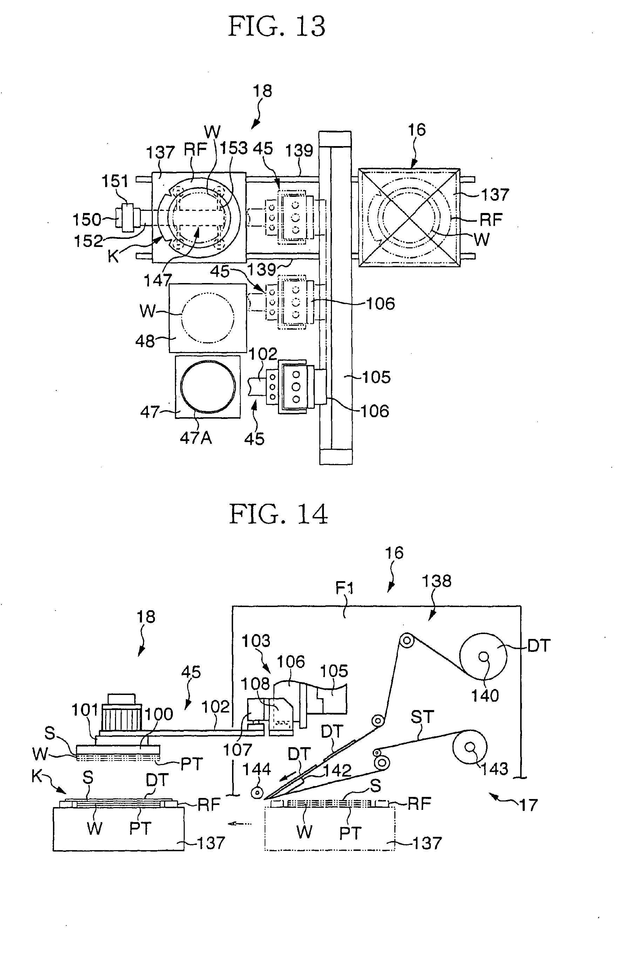

   Fig. 13 is a plan view schematically showing a wafer transferring area by a transfer unit.
[Fig. 14]
   Fig. 14 is a schematic front elevation view of a mounting unit.
[Fig. 15]

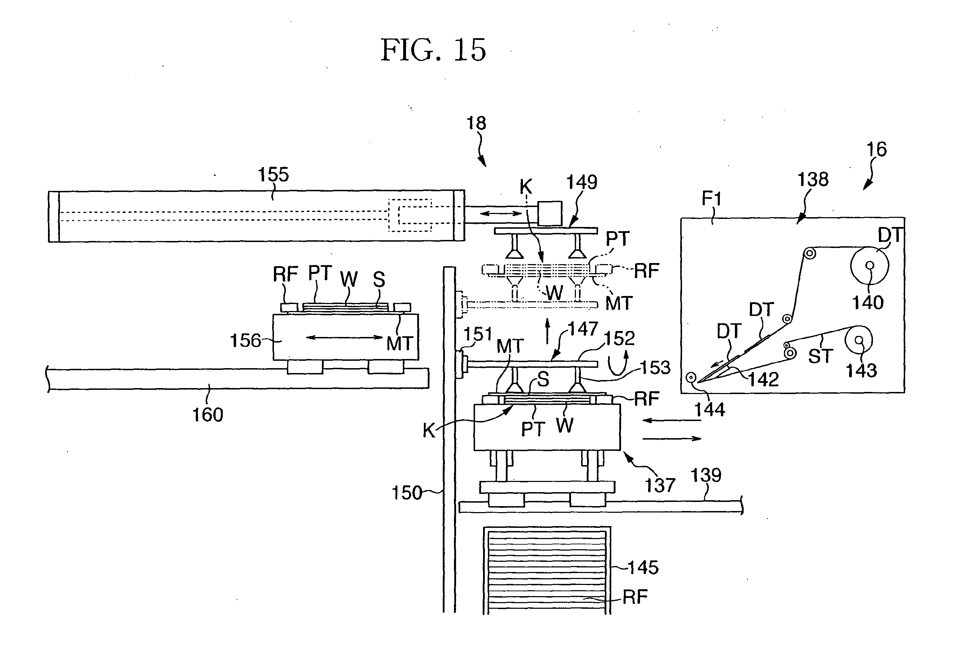

   Fig. 15 is a front elevation view schematically showing a transferring state of a work in which a wafer is mounted on a ring frame.
[Fig. 16]

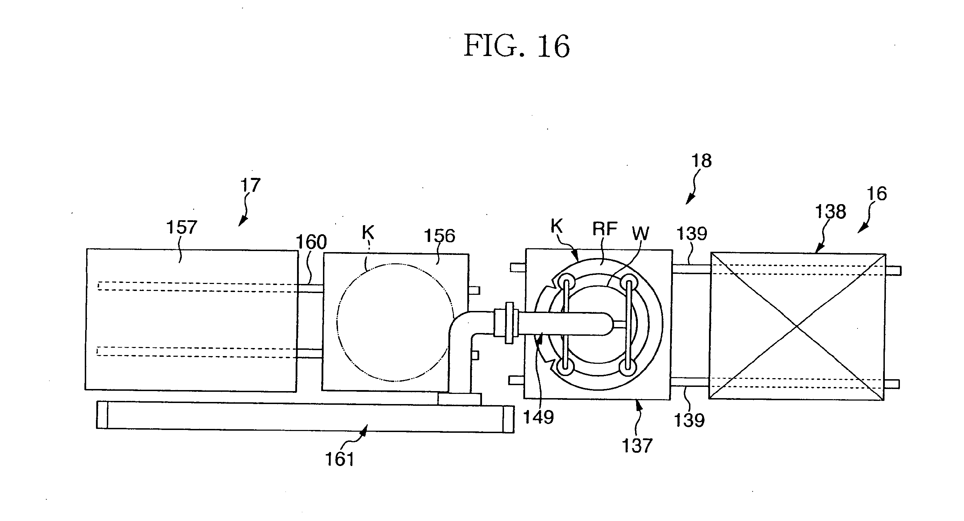

   Fig. 16 is a schematic plan view of a mounting unit.
[Fig. 17]

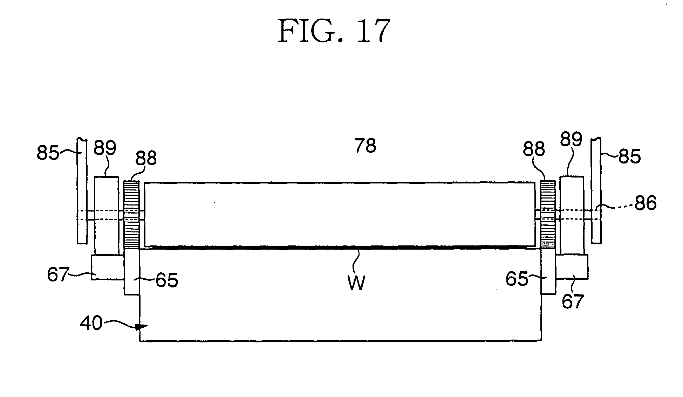

   Fig. 17 is a side view schematically showing another embodiment of the sticking table.

### EXPLANATION OF CODES

- 10: wafer processing apparatus
- 15: sticking apparatus
- 16: tape sticking unit
- 17: tape peeling unit
- 18: mounting unit
- 40: sticking table
- 40C: inner table section
- 40D: outer table section
- 41: sticking unit
- 44: heat transfer member
- 45: transfer unit
- 47: periphery cutting table
- 48: sticking table
- 101: temperature control unit
- 137: mount table
- W: semiconductor wafer
- PT: protection tape
- RF: ring frame
- S: adhesive sheet (heat sensitive adhesive sheet)
- S1: unnecessary portion of adhesive sheet

### BEST MODE FOR CARRYING OUT THE INVENTION

Hereinafter, embodiments of the present invention will be described with reference to the drawings.

Fig. 1 is a plan view showing a wafer processing apparatus in accordance with an embodiment of the present invention; Fig. 2 is a sectional view for schematically illustrating wafer processing steps in a time-lapse manner. Referring to these figures, a wafer processing apparatus 10 is arranged as a system that handles wafer W as an object, on which a UV cure protection tape PT (refer to Fig. 2) is stuck on the surface constituting a circuit plane, and performs a series of processes, including sticking a die bonding heat sensitive adhesive sheet S (hereinafter, referred to as "adhesive sheet S") on the rear surface of the wafer W, and thereafter mounting the wafer W to a ring frame RF by a dicing tape DT.

As shown in Fig. 1, the wafer processing apparatus 10 includes a cassette 11 that accommodates wafers W, a robot 12 that sucks and holds the wafer W taken out from the cassette 11, a UV irradiation unit 13 that irradiates UV to the protection tape PT, an alignment unit 14 that aligns the position of the wafer W, a sticking apparatus 15 that sticks the adhesive sheet S (refer to Fig. 2) to the rear surface of the aligned wafer W, a mounting unit 18 including a tape sticking unit 16 that sticks a dicing tape DT to the wafer W having the adhesive sheet S stuck thereon beforehand and mounts the wafer W on the ring frame RF and a tape peeling unit 17 that peels off the protection tape PT, and a stocker 19 that stores the wafer W from which the protection tape PT has been peeled off.

The wafers W are accommodated within the cassette 11 in a state that the protection tape PT comes to the upper face side, and the upper face side of the protection tape PT is held by the robot 12 and transferred to the UV irradiation unit 13. As shown in Fig. 3, the robot 12 includes an uniaxial shifter 21, a slider 22 that moves along the uniaxial shifter 21, a vertical movement mechanism 24 vertically provided to the slider 22, a joint type arm 26 that is provided to the upper end of the vertical movement mechanism 24 and is rotatable within the substantially horizontal plane, and a suction member 27 having a substantially C-like or substantially U-like plane shape provided to the front end of the arm 26. Here, the suction member 27 is connected to the front end of the arm 26 being interposed by a rotary mechanism 28, which is capable of inverting the surface of the wafer W upside down.

As shown in Fig. 3, the UV irradiation unit 13 includes a suction table 30 that sucks the wafer W, which has been sucked, held and transferred thereto by the suction member 27 of the robot 12, a UV lamp 31 disposed at a position above the suction table 30, and a case 32 that covers the suction table 30 and the UV lamp 31. The suction table 30 is arranged to be movable reciprocally in the right/left direction in Fig. 3 within the substantially horizontal plane by an unshown forward/reverse mechanism.

The alignment unit 14 includes an alignment table 34 that is arranged to be rotatable and to have an X-Y shift mechanism, a sensor 35 having a camera or the like for detecting unshown V-notch or the like in the wafer W, which is provided above the upper face side of the alignment table 34 and an uniaxial robot 37 that supports the alignment table 34 movable forward/backward with respect to the lower position of the conveyance plate 36.

The conveyance plate 36 is arranged so that the bottom face side works as a suction face and receives the wafer W, which has been subjected to UV irradiation, from the robot 12. Here, the wafer W is sucked by the suction face of the conveyance plate 36 being inverted to a state that the protection tape PT side comes to the bottom face side. The conveyance plate 36 is positioned above the alignment table 34 and arranged so as to be movable in the right/left direction in Fig. 1 by a conveyance robot 38. Such an arrangement is adopted that, when the conveyance plate 36 receives a UV irradiated wafer W from the robot 12, the alignment table 34 is moved to the bottom face side of the wafer W by the uniaxial robot 37 to receive the wafer W, then an alignment is carried out, and the wafer W is sucked by the conveyance plate 36 again and transferred to the sticking apparatus 15.

As shown in Fig. 3 through Fig. 5, the sticking apparatus 15 includes a sticking table 40 that receives the wafer W from the conveyance plate 36 and supports the wafer W, a sticking unit 41 that sticks temporarily the adhesive sheet S to the rear surface side (upper face side) of the wafer W sucked by the sticking table 40, a cutting means 43 that cuts the adhesive sheet S for each wafer W in the width direction, a transfer unit 45 that sucks and transfers the wafer W from the sticking table 40, a periphery cutting table 47 that sucks and supports the wafer W transferred by the transfer unit 45 and cuts an unnecessary portion of adhesive sheet S1 (refer to Fig. 4) protruding out of the periphery of the wafer W with the cutting means 43, a sticking table 48 that is provided together with the periphery cutting table 47 and for complete bonding of the adhesive sheet S stuck temporarily to the wafer W and a collector 50 that collects unnecessary portion of adhesive sheet S1, which is cut out at the periphery edge position of the wafer W.

The sticking table 40 is arranged so that, as shown in Fig. 4, the upper face side thereof is formed as a suction face and maintained to a first temperature, in this embodiment, to approximately 110°C at which the adhesive sheet S melts to a certain level and can be stuck temporarily to the wafer W. As shown in Fig. 8, the sticking table 40 includes a base table 40B, an inner table section 40C provided to the upper face side of the base table 40B and an outer table section 40D surrounding the inner table section 40C. The inner table section 40C is arranged to form a same plane shape substantially with that of the wafer W so as to serve as a support face for the wafer W, and a heater H is disposed therein to maintain the wafer W to a temperature of approximately 110°C. Further, a heat transfer member 44 is disposed in a clearance C formed between the inner table section 40C and the outer table section 40D. It is arranged so that the heat transfer member 44 maintains the temperature of the outer table section 40D lower than the temperature of the inner table section 40C; in this embodiment, to a temperature of approximately 40°C. Owing to this arrangement, the unnecessary portion of adhesive sheet S1 protruding out of the wafer W is stuck to the outer table section 40D with a weak adhesive force; thus, no wrinkles or the like are generated on the wafer when the adhesive sheet S is stuck to the wafer W.

The sticking table 40 is provided movably so as to be reciprocated between a position where the wafer W can be received from the conveyance plate 36 and a position above the periphery cutting table 47 passing through the lower area of the sticking unit 41 via a shifter 52. And the sticking table 40 is movable in the vertical direction via a lift unit 53. The sticking table 40 may be arranged so that the inner table section 40C and the outer table section 40D are rotatable within a plane. The shifter 52 includes a pair of rails 54, 54, a slide plate 55 that moves on the rails 54 being guided by these rails 54, a ball spline shaft 58 that goes through a bracket 57 fixed to the slide plate 55 in a state of screw engaging therewith, and a motor M (refer to Fig. 1) that drives the ball spline shaft 58 to rotate. The motor M is fixed to an unshown frame; and the other end side thereof is supported rotatable by the bearing 60. Accordingly, by driving the motor M to rotate forward/backward, the sticking table 40 moves to reciprocate in the right/left direction in Fig. 1 along the rails 54. The lift unit 53 includes a vertical movement mechanism 62 disposed in the central area of the bottom surface of the sticking table 40, a guide block 63 fixed on the slide plate 55, and four leg members 64, which are movable in the vertical direction along the guide block 63. It is arranged so that, when the vertical movement mechanism 62 goes forward/backward in the vertical direction, the sticking table 40 moves up/down to receive the wafer W from the conveyance plate 36.

Formed on the upper face of the sticking table 40 is a cutter receiving groove 40A for cutting the strip-shape adhesive sheet S in the width direction, which is paid out from the sticking unit 41. Provided on the upper portion of the both side faces along the shifting direction of the sticking table 40 are racks 65 constituting interlocking mechanisms and guide bars 67 attached to the outer side face of the racks 65.

As shown in Fig. 5 and Fig. 6, the sticking unit 41 is provided within the area of a plane-like frame F disposed above the sticking table 40. The sticking unit 41 includes a support roll 70 that supports so as to supply the adhesive sheet S wound in a roll shape, a drive roll 71 and a pinch roll 72 that impart pay-out force to the adhesive sheet S, a winding roll 73 that winds peeling sheet PS laminated on the adhesive sheet, two guide rolls 74, 74 disposed between the support roll 70 and the pinch roll 72 and a dancer roll 75 provided between these guide rolls 74 and 74, a pressurizing member 76 that presses the lead end area of the adhesive sheet S from which the peeling sheet PS has been peeled off against the upper face of the sticking table 40 to pinch the same, a press roll 78 that presses the adhesive sheet S against the rear surface side of the wafer W (upper face side in Fig. 5) to stick temporarily the same successively, a tension roll 79 and a guide roll 80 that are disposed immediately before the press roll 78 in the feeding direction of the adhesive sheet S. The press roll 78 includes a heater therein as a heating means. The bottom face side of the pressurizing member 76 has a sucking section to suck and hold the end portion of the adhesive sheet S.

The drive roll 71, pinch roll 72 and winding roll 73 form a peel-off section that peels the adhesive sheet S from the peeling sheet PS in an original state. The rolls 71 and 73 are arranged to be driven to rotate by the motors M1 and M2 provided at the backside of the frame F. The pressurizing member 76 the press roll 78 and the tension roll 79 are arranged movable in the vertical direction by the cylinders 82, 83 and 84 respectively. As shown in Fig. 7 and Fig. 8, the press roll 78 is arranged so that the both end sides are connected to the cylinder 83 via a bracket 85, and at the both ends of the rotational center shaft 86, a pair of pinions 88, 88 each constituting an interlocking mechanism that interacts with the rack 65, and at the further outer position of these pinions 88, a pair of rollers 89 and 89 are disposed as rotary members. The pinions 88, 88 are arranged to engage with the racks 65; and the rollers 89, 89 rotate on the guide bars 67 irrespective of the rotation of the press roll 78.

As shown in Fig. 5 and Fig. 6, the cutting means 43 includes an arm 90 extending along the shifting direction of the sticking table 40 and the cutter unit 92 disposed on the bottom surface at the front end side (left end side in Fig. 5) of the arm 90, movably forward/backward by an uniaxial robot 91. The cutter unit 92 includes a cylinder 95 for moving the cutter vertically supported by the bracket 94, which moves along the uniaxial robot 91, and a cutter 96 attached to the front end of the cylinder 95 for vertical cutter movement. Here, the cylinder 95 for vertical cutter movement is attached to the bracket 94 in a rotatable state within a substantially vertical plane. Owing to this, the angle of the cutter blade can be adjusted in a state that the cutter end position of the cutter 96 is pursuing an arc trace within the substantially vertical plane, the cutter 96 can be set not to allow the adhesive sheet S to extrude out of the wafer W when performing circumference cutting, which will be described later, and is movable along the extending direction of the arm 90 by the uniaxial robot 91. As shown in Fig. 1, the cutting means 43 is supported movably by motor M3 driving on a guide 97 oriented to the direction perpendicular to the shifting direction of the sticking table 40(Y-direction in Fig .1). Accordingly, the cutter 96 is maintained at a posture in which the front end thereof enters a cutter receiving groove 40A on the sticking table 40. Thus, when the entire cutting means 43 moves along the guide 97, a function to cut the adhesive sheet S in the width direction is achieved.

As shown in Fig. 4 and Fig. 9 through Fig. 14, the transfer unit 45 includes a plane shaped suction plate 100 that sucks the wafer W on the bottom face side, a temperature control unit 101 provided at the upper face side of the suction plate 100, an arm 102 that supports the suction plate 100 and an uniaxial robot 105 that moves the arm 102 to the Y-direction. The suction plate 100 has such a function that, when the suction plate 100 sucks the wafer W after the adhesive sheet S has been cut in the width direction on the sticking table 40 (refer to Fig. 10), to cool down the wafer W having a temperature (110°C) of a first temperature for temporarily sticking, to a temperature of, for example, ambient temperature to reduce or eliminate the viscosity of the adhesive sheet S; thus, the adhesive agent is prevented from transferring to the cutter 96. Also, the transfer unit 45 has a function to transfer the wafer W from the sticking table 40 to the periphery cutting table 47, and to transfer the wafer W, from which the unnecessary portion of adhesive sheet S1 has been cut off by the periphery cutting table 47, to the sticking table 48, and further to transfer the wafer W after the adhesive sheet S has been stuck completely by the sticking table 48 to the following process step. The transfer unit 45 is arranged so that, in any of the following steps; i.e. , during transferring the wafer from the sticking table 40 to the periphery cutting table 47, during transferring the wafer from the periphery cutting table 47 to the sticking table 48 and during transferring the wafer from the sticking table 48 to the mounting unit 18, the temperature control unit 101 controls the temperature of the wafer W; thus, the period of time for controlling the temperature after transferring the wafer can be reduced or eliminated.

As shown in Fig. 4, the uniaxial robot 105 is disposed in an area above the guide 97 of the cutting means 43 substantially parallel to the guide 97. The uniaxial robot 105 is provided with a cylinder 106 extending in the vertical direction perpendicular to the direction of the uniaxial robot 105, and a lift slider 108, which is movable in the vertical direction by the cylinder 106. The base end side (right end side in Fig. 9) of the arm 102 is connected to the lift slider 108.

As shown in Fig. 4, Fig. 11 and others, the periphery cutting table 47 is a table for receiving the wafer W from the sticking table 40 via the transfer unit 45 and sucking the same to cut the unnecessary portion of the adhesive sheet S1 around the wafer W with the cutting means 43. According to this embodiment, the periphery-cutting table 47 is to be maintained to the ambient temperature as a second temperature; the upper face thereof is formed as a suction face and is provided with a circumference groove 47A corresponding to the peripheral edge of the wafer W. The periphery cutting table 47 is supported on the lift plate 111 via a rotary mechanism 110 at the bottom face side thereof. The rotary mechanism 110 includes a rotary shaft 112 of which axial line direction is oriented to the vertical direction, a rotary bearing 103 supporting the rotary shaft 112, a driven pulley 114 fixed around the rotary shaft 112, a main driving pulley 115 located at the side of the driven pulley 114 and fixed to the output shaft of a motor M4, and a belt 117 laid around the pulleys 114 and 115. The periphery cutting table 47 is arranged to rotate within a plane when the main driving pulley 115 is driven to rotate by the motor M4. Accordingly, when the cutter 96 enters into the circumference groove 47A and the periphery cutting table 47 is rotated, cutting function of the adhesive sheet S in the periphery direction; i.e. , a circumference cut is achieved. The cutting in the periphery direction can be also achieved by arranging the cutter unit 92 to be rotatable within a horizontal plane.

The lift plate 111 supporting the periphery cutting table 47 is arranged to be movable in the vertical direction by a lift unit 120. As shown in Fig. 4, the lift unit 120 includes a block 123 that is attached to the backside of a support member 122 having a substantially L-like shape, which supports the lift plate 111, a pair of lift side plates 124 connected to the both sides of the support member 122, a pair of uprising guides 125 that guide these lift side plates 124 in the vertical direction, a screw shaft 126 that extends through the block 123 in the vertical direction, pulleys 127 and 128 each fixed to the lower end of the screw shaft 126 and the output shaft of a motor M5 disposed adjacent to the lower end of the uprising guides 125 and a belt 129 laid around these pulleys 127 and 128. Rotation of the screw shaft 126 by the motor M5 enables the vertical movement of the periphery cutting table 47.

The sticking table 48 is disposed in a side area above the periphery cutting table 47 via an unshown frame. The sticking table 48 is arranged so that the upper face is formed as a suction face, the wafer W is transferred from the periphery cutting table 47 by the transfer unit 45, and the wafer W, which is stuck temporarily with the adhesive sheet S, is heated to stick the adhesive sheet S completely to the wafer W. In this embodiment, the sticking table 48 is controlled to approximately 180°C as a third temperature.

The collector 50 is a unit that sucks and collects the unnecessary portion of adhesive sheet S1 around the wafer W on the cutting table 47. The collector 50 includes cross arms 130 having a substantially X-like shape viewed from the top, each extreme end of which is provided with a suction function on the bottom face thereof, a joint arm 131 that supports the substantially center position of the cross arm 130, a cylinder 132 that supports the base end side of the joint arm 131 and is disposed in the direction substantially perpendicular to the guide 97 of the cutting means 43 within a plane, a slider 133 that is movable along the cylinder 132 and a collection box 135 that collects the unnecessary portion of adhesive sheet S1. The cross arm 130 is arranged to be movable to reciprocate between a position above the periphery cutting table 47 and a position above the collection box 135, when the suction to the unnecessary portion of adhesive sheet S1 is released above the collection box 135, the unnecessary portion of adhesive sheet S1 drops into the collection box 135.

The wafer W, which has been completely stuck with the adhesive sheet S on the sticking table 48, is transferred to the mounting unit 18 side again by the transfer unit 45. Here, the transfer unit 45 that sucks the wafer W is arranged to cool down the wafer W through the temperature control unit 101 during the transferring process. As shown in Fig. 1 and Fig. 13 through Fig. 16, the tape sticking unit 16 includes a mount table 137 that sucks a ring frame RF and the wafer W and a pair of rails 139 that allows the mount table 137 to move toward a tape sticking section 138 that sticks dicing tape DT. Here, as for the dicing tape DT, a peeling tape ST continuing in a strip-shape, which is temporarily stuck with dicing tape pieces having a size slightly smaller than the outer diameter of the ring frame RF on one surface, is used as an original roll.

The mount table 137 is schematically shown in the figure. The mount table 137 employs an arrangement substantially identical to that of the above-described sticking table 40. Owing to this, the mount table 137 is movable in the vertical direction as well as along the rails 139.

The tape sticking section 138 includes a support roll 140 that is provided within the plane of a plane-like support frame F1 and supports the dicing tape DT wound in a roll shape enabling to pay out, a peel plate 142 that sharply turns over the peeling tape ST paid out from the support roll 140; thereby peels off the dicing tape DT, a winding roll 143 that winds the peeling tape ST turned over by the peel plate 142 and press roll 144 that presses and sticks the dicing tape DT to the upper surface of the ring frame RF and adhesive sheet. Accordingly, as shown in Fig. 14, after the mount table 137 is moved to the tape sticking section 138 side, the position of the upper face of the mount table 137 is raised and the mount table 137 is moved to the direction indicated with solid line at the left side in the figure; thereby the dicing tape DT is stuck on the upper face of the ring frame RF and adhesive sheet S. Thus, the wafer W can be mounted on the ring frame RF. As shown in Fig. 15, the ring frames RF are accommodated in a frame stocker 145 and transferred on the mount table 137 by the transfer arm 147. A work K mounted on a ring frame RF on the mount table 137 is sucked and held by the transfer arm 147. In a state that the work K is inverted upside down, the transfer arm 147 transfers the work K to the transport arm 149, and the work K held by the transport arm 149 is transferred to a processing position of the next step.

As shown in Fig. 15, the transfer arm 147 includes a slider 151 arranged to be movable in the vertical direction along a guide column 150, an arm 152 supported by the slider 151 and branching arms 153 that extend in all direction from the arm 152 and suck the ring frame RF. The arm 152 is arranged to be rotatable around the axial line thereof. Owing to this, the work K is arranged to be able to be transferred to the transport arm 149 in a state that the protection tape PT comes to the upper face side.

The transport arm 149 is provided movably in the right/left direction in Fig. 15 by the cylinder unit 155. The transport arm 149 has substantially the same structure as that of the transfer arm 147 except that no rotary function is included.

The work K sucked and held by the transport arm 149 is transferred to the tape-peeling unit 17. The tape-peeling unit 17 includes a peeling table 156 and, as shown in Fig. 16, a tape peeling section 157 that peels the protection tape PT from the work K transferred to the peeling table 156. The peeling table 156 is arranged to be movable along the rails 160; during the shifting, the protection tape PT at the upper face side is peeled off. The work K, from which the protection tape PT has been peeled off by the tape peeling section 157 is transferred to conveyance rails 162 by an unshown transfer mechanism, moved on the conveyance rails 162 by a work conveyance cylinder 161 and received by a stocker 19. The work K received by the stocker 19 is subjected to dicing into a chip size and heat treatment in the following process, and then picked up and subjected to the bonding.

Next, the wafer processing step in this embodiment will be described.

Many wafers W, to which a protection tape PT is stuck on the circuit plane, are accommodated in the cassette 11. The wafer W is transferred to the UV irradiation unit 13 by the robot 12 and subjected to a predetermined UV processing. After the UV cure processing, the wafer W is transferred to the conveyance plate 36 by the robot 12.

After the wafer W has been transferred to the alignment table 34 by the conveyance plate 36 and an alignment processing is carried out, the wafer W is transferred to the sticking table 40 again by the conveyance plate 36. Here, the sticking table 40 is controlled to maintain to substantially 110°C as a first temperature at which the inner table section 40C can stick temporarily the adhesive sheet S. On the other hand, the outer table section 40D is controlled to a temperature of approximately 40°C at which the adhesive sheet S adheres with weak adhesive force. The wafer W is sucked in a state that the protection tape PT comes into contact with the table surface; i.e., in a state that the rear surface of the wafer W comes to the upper face side accordingly.

As shown in Fig. 5, when the sticking table 40 moves to a predetermined position of the sticking unit 41, the lead end area of the adhesive sheet S, which is sucked and held at the bottom face side of the pressurizing member 76 is brought into contact with the upper face of the sticking table 40 by the lowering operation of the pressurizing member 76. After the contact has been achieved, the press roll 78 lowers to pinch the adhesive sheet S between the upper face of the wafer W and the press roll 78, and the unnecessary portion of the adhesive sheet S1 other than the area of the wafer W is brought into contact with the outer table section 40D (refer to Figs. 5, 7 and 8). Then, the pressurizing member 76 releases the suction and rises. Meanwhile, the rollers 89, which are provided to the both end sides of the press roll 78, come into contact with the upper face of the guide bars 67. At the same time, pinions 88 engage with racks 65 and the pinions 88 can rotate and move along the racks 65. In this state, the sticking table 40 moves rightward in Fig. 5. Owing to the engagement between the racks 65 and the pinions 88, the press roll 78 rotates and the rollers 89 rotate on the guide bars 67 as guide faces, the adhesive sheet S, which is paid-out successively is stuck on the upper face of the wafer W. During this sticking operation, the unnecessary portion of adhesive sheet S1 extruding out of the periphery of the wafer W is stuck to the outer table 40D with a weak adhesive force. Accordingly, while the press roll 78 rotates and moves on the wafer W, since the adhesive sheet S is pulled by the tension of the adhesive sheet S and the press force of the press roll 78. Thus, such a disadvantage that wrinkles are generated does not occur. The press roll 78 is controlled to maintain to substantially 110°C by the heater as a built-in heating means.

As described above, when the adhesive sheet S has been stuck on the wafer W and the pressurizing member 76 has come to a position above the cutter receiving groove 40A immediately after the pressurizing member 76 has passed the same, the sticking table 40 has arrived at a position substantially just above the periphery cutting table 47. Then, the pressurizing member 76 lowers to bring the adhesive sheet S into contact with the sticking table 40 (refer to Fig. 6). Thereafter, the cutter 96 of the cutting means 43 enters into the cutter receiving groove 40A, and the arm 90 supporting the cutter unit 92 moves in the direction perpendicular to the figure plane of Fig. 6 to cut the adhesive sheet S in its width direction. Here, since the area of the adhesive sheet S corresponding to the cutter receiving groove 40A is not brought into contact with the table surface , the viscosity of the area is in a low state. Accordingly, no problem such that the adhesive agent transfers to the cutter 96 occurs. When the cutting in the width direction has completed, the pressurizing member 76 sucks the adhesive sheet S positioned at the bottom face side of the pressurizing member 76 and returns to the upper end position and stands by for sticking the next wafer W. When the cylinder 95 for the cutter vertical movement rises, the cutting means 43 shifts to a position in which the position of the blade of the cutter 96 rises to escape in the direction away from the position of the upper face of the sticking table 40; i.e., upward direction in Fig. 1.

Then, as shown in Fig. 9, the suction plate 100 of the transfer unit 45 moves to a position above the sticking table 40 by the motion of the uniaxial robot 105 and the cylinder 106, and when the cylinder 107 lowers, the position of the face of the suction plate 100 is lowered to suck and hold the wafer W, on which the adhesive sheet S has been stuck already. Accordingly, the sticking table 40 moves to a position for sucking and holding a wafer W as a subsequent work piece. At the same time, the periphery cutting table 47 rises, and the wafer W sucked by the suction plate 100 is transferred to the upper face of the cutting table 47. In this way, the wafer W, which has been heated temporarily to a sticking temperature by the sticking table 40, is subjected to a temperature control operation (cooling operation) while being sucked by the suction plate 100, and is maintained in a state being cooled down to the substantially ambient temperature.

As shown in Fig. 11, when the wafer W is transferred to the periphery cutting table 47 and sucked and held thereby, the transfer unit 45 moves in the direction away from the position above the periphery cutting table 47. On the other hand, the cutting means 43 moves to a position above the periphery cutting table 47 (refer to Fig. 12). Then, the predetermined amount motion of uniaxial robot 91 and the descent of the cylinder 95 for cutter vertical movement, makes the cutter 96 penetrates to the rear side at a position substantially corresponding to the periphery edge of the wafer W and the extreme edge thereof is received within the circumference groove 47A. In this state, the periphery cutting table 47 is rotated within a horizontal plane by the rotary mechanism 110, and the unnecessary portion of adhesive sheet S1 extruding out of the periphery of the wafer W is cut along the periphery thereof. When the cutting has completed, the cutting means 43 moves to a retreated position from the position above the periphery cutting table 47. Meanwhile, the cross arm 130 of the collector 50 moves to a position above the unnecessary portion of adhesive sheet S1 to suck the same, moves to a position above the collection box 135, and drops the unnecessary portion of adhesive sheet S1 thereinto.

Immediately after the cross arm 130 moves to the collection box 135 side, the transfer unit 45 moves to a position in exchange above the periphery cutting table 47, and transfers the wafer to the upper face of the sticking table 48 after sucking the wafer W again, while heating the wafer W up to a temperature necessary for completely adhering the same by the temperature control unit.

The wafer W transferred to the sticking table 48 is brought to a stage that the adhesive sheet S is stuck completely thereon due to the fact that the sticking table 48 is controlled to maintain the temperature of substantially 180°C as a third temperature. Then, after a predetermined time has passed, the wafer W is sucked by the suction plate 100 of the transfer unit 45, and subjected to a temperature control operation to return to the ambient temperature again.

The wafer W of which temperature has been lowered while being sucked by the transfer unit 45 is mounted on the ring frame RF interposed by the dicing tape DT, after transferred to the mount table 137 sucking the ring frame RF. In the case where the wafer W is an aggregation of chips W1 separated in a prior dicing operation, the mount table 137 is rotated a predetermined angle within horizontal plane to control so that the center axial line of the press roll 144 is not parallel to any side of any chip W. And in this state, the dicing tape (mount tape) DT is stuck on the adhesive sheet S. Owing to this, the wafer W is prevented from being inclined by the press force of the press roll 144; thus, the mount tape can be stuck precisely.

The work K, which is composed of wafer W mounted on the ring frame RF, is accommodated in the stocker 19, after transferred to the peeling table 156 in the state being inverted upside down and the protection tape PT is peeled off.

As described above, according to the embodiment of the present invention, when the wafer W is transferred from the sticking table 48 of the sticking apparatus 15 to the mount table 137, the temperature of the wafer W is controlled. Accordingly, since temperature control is not required at the mount table 137, the mount processing can be achieved free from complicated structure of the mounting unit 18 side. Furthermore, during the transfer operation, the wafers being transferred among the tables are subjected to the temperature control operation. In this point also, the wafer processing efficiency is enhanced.

Further, each of the inner table section 40C and the outer table section 40D constituting the sticking table 40 is arranged so that the temperature can be controlled. Accordingly, such advantages can be achieved simultaneously as prevention of wrinkles caused by the unnecessary portion of adhesive sheet S1 existing at the periphery side of the wafer W.

As described above, best arrangement, method and the like for carrying out the present invention have been disclosed in the above description. However, the present invention is not limited to the above.
That is, although the present invention is particularly illustrated and described mainly with respect to a particular embodiment, one skilled in the art can add various modifications, if necessary, to the above described embodiment with respect to configuration, position, disposition or the like without departing from the range of technical idea and object of the present invention.

For example, in the embodiment, the sticking table 40 includes the inner table section 40C and the outer table section 40D. However, as shown in Fig. 17, a sticking table 40 may be arranged to have a built-in heater, which can maintain the whole unit at the first temperature.

Also, the sticking apparatus 15 has been illustrated and described as an apparatus that sticks the die bonding adhesive sheet S to the wafer W. However, if the sheet has a heat sensitive adhesive characteristic, any other sheets may be employed. For example, the sticking apparatus 15 may be applied to a case where a dry resist film sheet or a protection film or the like is stuck to the wafer W.

Further, layout, transferring direction or the like of each constituting unit of the wafer processing apparatus 10 are not limited to the illustrated examples of the arrangement. If the identical processing can be carried out, any arrangement is acceptable.

Furthermore, the temperatures of the sticking table 40, periphery cutting table 47 and sticking table 48 do not limit the present invention, but may be flexible in accordance with the characteristics of the employed heat sensitive adhesive sheet.

## Claims

1. A wafer processing apparatus, comprising:
tables for supporting an object;
a sticking unit for supplying a heat sensitive adhesive sheet to the upper face of said object to stick the adhesive sheet to the object; and
a cutting means for cutting said adhesive sheet for each individual object,
wherein said tables are controlled to a first temperature at which said adhesive sheet is stuck temporarily, a second temperature at which the adhesion of said adhesive sheet is reduced and the adhesive sheet around the object is cut off, and a third temperature at which the adhesive sheet is stuck completely to the object.

2. The wafer processing apparatus according to claim 1, wherein said tables include each individual table so as to maintain the objects to said first, second or third temperature.

3. A wafer processing apparatus, comprising:
tables for supporting a semiconductor wafer as the object;
a sticking unit for supplying and sticking a heat sensitive adhesive sheet having a strip-shape to the upper face side of the semiconductor wafer; and
a cutting means for cutting said adhesive sheet for each semiconductor wafer,
wherein said cutting means has a width direction cutting function to cut said adhesive sheet in the width direction and a periphery direction cutting function to cut the adhesive sheet along the periphery of the semiconductor wafer,
said tables include a sticking table that is controlled to a first temperature and sticks temporarily said adhesive sheet to the semiconductor wafer, a periphery cutting table that is controlled to a second temperature lower than the first temperature and cuts the adhesive sheet around said semiconductorwafer, and an sticking table that is controlled to a third temperature that becomes higher than said first temperature and sticks completely the adhesive sheet to the semiconductor wafer.

4. The wafer processing apparatus according to claim 3, further comprising a transfer unit for transferring said semiconductor wafer, wherein the transfer unit includes a temperature control unit for controlling the temperature of the semiconductor wafer while transferring said semiconductor wafer between said tables.

5. The wafer processing apparatus according to claim 3, further comprising a transfer unit for transferring the semiconductor wafer stuck completely with said adhesive sheet to a mounting unit, wherein the transfer unit includes a temperature control unit for controlling the temperature of the semiconductor wafer while transferring the semiconductor wafer to the mounting unit.

6. The wafer processing apparatus according to claim 3, wherein said sticking table includes an inner table section and an outer table section surrounding the inner table section, the outer table section is controlled to a temperature lower than that of said inner table section.

7. The wafer processing apparatus according to claim 6, wherein a heat transfer member is interposed between said inner table section and outer table section, the heat transfer member heats the outer table section to a temperature lower than that of the inner table section.

8. The wafer processing apparatus according to claims 6 or 7, wherein each of said inner table section and outer table section is controlled independently to respective temperatures.

9. The wafer processing apparatus as in any of claims 1-3, wherein said adhesive sheet is a die bonding sheet.

10. The wafer processing apparatus according to claim 3, wherein said adhesive sheet is a protection sheet which is cured to form a protection film.

11. The wafer processing apparatus according to claim 3, wherein said cutting means includes a cutter, the extreme end position of the cutter is arranged adjustable in its position between a position for cutting the adhesive sheet in the width direction and a position for cutting the adhesive sheet along the peripheral edge of the object.

12. A wafer processing method of sticking a heat sensitive adhesive sheet having a strip-shape to the upper face side of the semiconductorwafer, comprising the steps of : sticking temporarily said adhesive sheet to the semiconductor wafer while maintaining said semiconductor wafer or a table supporting the same to a first temperature;
maintaining the semiconductorwafer stuck temporarily with said adhesive sheet to a second temperature that is lower than the first temperature; thereby reducing the adhesion of the adhesive sheet, and cutting a sheet portion around the semiconductor wafer; and
controlling the temperature of said semiconductor wafer and adhesive sheet to a third temperature that is higher than the first temperature; thereby sticking completely the adhesive sheet to the semiconductor wafer.

13. The wafer processing method according to claim 12, further comprising a step of transferring the semiconductor wafer having said adhesive sheet stuck completely thereto to a mounting unit via a transfer unit, and cooling down the semiconductor wafer through said transfer unit during the transfer step.
